# EUROPÄISCHE PATENTANMELDUNG

(11) **EP 3 835 622 A1**
(43) Veröffentlichungstag der Anmeldung: **16.06.2021**
(21) Anmeldenummer: 19214760.1
(22) Anmeldetag: 10.12.2019
(51) Int. Cl.: F16H 57/027, F03D 15/00, F16H 57/04, F16H 57/01, G05B 19/042, G06F 13/40, H03K 19/0175

(54) **LUFTFILTEREINRICHTUNG, GETRIEBE, VERFAHREN, ANTRIEBSSTRANG, WINDKRAFTANLAGE UND INDUSTRIE-APPLIKATION**

(71) Anmelder: Flender GmbH, 46395 Bocholt (DE); Siemens Aktiengesellschaft, 80333 München (DE)
(72) Erfinder: Furtmann, Alexander, 46399 Bocholt (DE); Henseler, Felix, 47877 Willich (DE); Huck, Ralf, 63538 Großkrotzenburg (DE)
(74) Vertreter: Michalski Hüttermann & Partner Patentanwälte mbB

(57) **Zusammenfassung**

Die Erfindung betrifft eine Luftfiltereinrichtung (3), die dazu ausgelegt ist, einen Druckausgleich zwischen dem Innenraum eines Getriebes (1) und der Umgebung zu ermöglichen, umfassend einen Strömungskanal (17) und zumindest ein in den Strömungskanal (17) eingesetztes Filterelement (18), dadurch gekennzeichnet, dass die Luftfiltereinrichtung (3) zumindest einen Sensor (11, 12, 20) zur Erfassung einer den Betriebszustand des Getriebes (1) repräsentierenden Messgröße aufweist. Ferner betrifft die Erfindung ein Getriebe (1) mit einer solchen Luftfiltereinrichtung (3), ein Verfahren zur Inbetriebnahme und zur Verwendung eines Getriebes (1). Zudem betrifft die Erfindung einen Antriebsstrang (26), eine Windkraftanlage (22) und eine Industrie-Applikation (28), die jeweils ein solches Getriebe (1) aufweisen.

## Beschreibung

Die Erfindung betrifft eine Luftfiltereinrichtung, die dazu ausgelegt ist, einen Druckausgleich zwischen dem Innenraum eines Getriebes und der Umgebung zu ermöglichen, umfassend einen Strömungskanal und zumindest ein in den Strömungskanal eingesetztes Filterelement. Ferner betrifft die Erfindung ein Getriebe mit einem Getriebegehäuse, an dem eine solche Luftfiltereinrichtung befestigt ist, sowie ein Verfahren zur Inbetriebnahme und zur Verwendung eines solchen Getriebes. Zudem betrifft die Erfindung einen Antriebsstrang, eine Windkraftanlage und eine Industrie-Applikation, die jeweils ein solches Getriebe aufweisen.

Getriebe sind im Allgemeinen mit Öl gefüllt, um bestimmte Getriebekomponenten zu schmieren und/oder zu kühlen, wie beispielsweise Lagerungen oder dergleichen. Der Innenraum eines Getriebes umfasst dann einen Ölsumpf und ein Luftvolumen. Durch die Erwärmung während des Betriebs kommt es zu einer Volumenänderung des Öls, welche bei geschlossenem Getriebegehäuse zu einer Druckänderung führt. Wellendichtringe, die zur Abdichtung des Getriebes genutzt werden, können allerdings nur einem bestimmten Überdruck ausgesetzt werden, bevor sie ihre dichtende Funktion verlieren und entsprechend versagen. Es ist daher erforderlich, die Druckänderungen im Innenraum des Getriebes auszugleichen. Hierfür werden häufig Luftfiltereinrichtungen eingesetzt, die dazu ausgelegt sind, einen Druckausgleich zwischen dem Innenraum eines Getriebes und der Umgebung zu ermöglichen. Die Luftfiltereinrichtungen umfassen einen Strömungskanal und zumindest ein in den Strömungskanal eingesetztes Filterelement, das die Gase filtert, die das Filterelement im Rahmen eines Druckausgleichs passieren. Bei dem Filterelement kann es sich beispielsweise um einen reinen Luftfilter handeln, der Partikel aus dem durch das Filterelement strömenden Gas filtert. Alternativ können aber auch Nassluftfilter eingesetzt werden, die zusätzlich verhindern, dass Feuchtigkeit aus der Umgebung in den Innenraum des Getriebes gelangen kann.

Ferner ist es dem Stand der Technik grundsätzlich bekannt, Getriebe mit unterschiedlichen Sensoren zu versehen, um den Betriebszustand des Getriebes repräsentierende Messgrößen zu erfassen.

Eine solche Messgröße stellt der Ist-Zustand des Öls dar. Während des Betriebs von mit Öl gefüllten Getrieben kommt es zu einer Alterung des Öls durch verschiedene Prozesse wie Oxidation, Additivabbau, Kontamination mit Fremdstoffen oder dergleichen. Die Leistungsfähigkeit des Öls nimmt daher im Laufe der Zeit ab, bis diese irgendwann nicht mehr ausreicht, um die geforderten Funktionen der Schmierung, des Schutzes vor Korrosion, der Kühlung etc. zu erfüllen. Um einen optimalen Betrieb des Getriebes zu gewährleisten, muss daher sichergestellt werden, dass das Öl noch leistungsfähig ist. Ist dies nicht mehr der Fall, so müssen dem Öl zeitnah Additive zugesetzt oder das Öl vollständig gewechselt werden. Der genaue Zeitpunkt, wann ein Öl seine Leistungsfähigkeit verliert, lässt sich allerdings nur schwer vorhersagen, da viele Einflüsse die Lebensdauer des Öls beeinflussen, wie beispielsweise Betriebstemperaturen, Betriebsstunden, Belastungen, Verunreinigungen, Bauteilverschleiß oder dergleichen. Vor diesem Hintergrund gibt es verschiedene Wege, den Zeitpunkt für eine Ölaufbereitung oder einen Ölwechsel festzulegen. Ein erster Weg ist die Bestimmung fester Intervalle für einen Ölwechsel, beispielsweise nach einer festen Anzahl von Betriebsstunden. Hierbei wird der Zustand des Öls nicht betrachtet, weshalb zwei Effekte eintreten. Zum einen kann das Öl zu früh gewechselt werden, so dass es unnötigerweise bereits gewechselt wird, obwohl es noch leistungsfähig ist, was ressourcenvergeudend ist. Zum anderen kann das Öl zu spät gewechselt werden, wodurch es zu einer Schädigung des Getriebes kommen kann. Ein anderer Weg ist der Ölwechsel auf Basis des tatsächlichen Ist-Zustands des Öls, der durch Analyse von Ölproben ermittelt wird. Dazu werden in regelmäßigen Abständen manuell Ölproben gezogen und detailliert im Labor analysiert. Je nach Probenintervall kann der Ölwechsel damit sehr gezielt zum optimalen Ende der Öllebensdauer gelegt werden. Noch ein weiterer Weg ist der Einsatz von mobiler oder fest installierter Sensorik. Diese kann beispielsweise innerhalb eines Ölkreislaufs eingesetzt werden und die Eigenschaften des Öls direkt analysieren. Dies geschieht beispielsweise über Messung der Dielektrizitätszahl, des Wassergehalts, des Infrarotspektrums oder des Gehalts an Partikeln. Eine mobile und stationäre Variante stellt auch die Analyse des Ölzustands aus der Dampfphase des Öls dar. Bei dieser wird eine Probe des Öldampfes mit Hilfe der Ionenmobilitätsspektrometrie ("IMS") analysiert und auf Veränderungen zum Frischölzustand hin geprüft.

Eine weitere den Betriebszustand des Getriebes repräsentierende Messgröße ist die Ist-Temperatur. Zur Erfassung der Ist-Temperatur werden beispielsweise Widerstandsthermometer oder Thermoelemente genutzt, die meist im Ölsumpf oder an einem Lager angebracht sind.

Noch eine weitere Messgröße sind Schwingungen, deren Erfassung unter Verwendung von Schwingungssensoren erfolgen kann, beispielsweise in Form von Beschleunigungssensoren auf MEMS-Basis oder von Piezzo-Beschleunigungsaufnehmern. Solche Schwingungssensoren werden häufig an Lagersitzen angebracht und nehmen ein- oder mehrachsig Beschleunigungen auf.

Ausgehend von diesem Stand der Technik ist es eine Aufgabe der vorliegenden Erfindung, den Aufbau von Getrieben zu vereinfachen, ohne dabei einen ordnungsgemäßen Druckausgleich oder eine ordnungsgemäße Erfassung von den Betriebszustand des Getriebes repräsentierenden Messsignalen zu gefährden.

Zur Lösung dieser Aufgabe schafft die vorliegende Erfindung eine Luftfiltereinrichtung, die dazu ausgelegt ist, einen Druckausgleich zwischen dem Innenraum eines Getriebes und der Umgebung zu ermöglichen, umfassend einen Strömungskanal und zumindest ein in den Strömungskanal eingesetztes Filterelement, dadurch gekennzeichnet, dass die Luftfiltereinrichtung zumindest einen Sensor zur Erfassung einer den Betriebszustand des Getriebes repräsentierenden Messgröße aufweist.

Die Sensorik zur Erfassung von den Betriebszustand des Getriebes repräsentierende Messgrößen ist erfindungsgemäß in die Luftfiltereinrichtung integriert. Dies ist dahingehend vorteilhaft, dass eine zeitaufwendige und kostspielige Positionierung separater Sensoren im Innenraum des Getriebegehäuses entfällt. Die erfindungsgemäße Luftfiltereinrichtung muss lediglich in gewohnter Weise am Getriebegehäuse montiert werden. Somit stellt die erfindungsgemäße Luftfiltereinrichtung auch eine einfache Möglichkeit für die Nachrüstung von Bestandsgetrieben dar, um diese zu smarten bzw. digitalen Getrieben aufzuwerten. Zum anderen ergibt sich der Vorteil einer sehr konstanten Sensorpositionierung. Dadurch werden Messabweichungen minimiert.

Die von dem zumindest einen Sensor aufgenommenen Messsignale können drahtgebunden oder drahtlos an eine Auswerteeinheit übermittelt werden, um die Sensorsignale auszuwerten, indem diese mit Referenzdaten verglichen werden. Werden vorab definierte Grenzwerte überschritten, so kann ein Warnsignal ausgegeben werden, um dem Wartungspersonal anzuzeigen, dass zeitnah entsprechende Gegenmaßnahmen getroffen werden müssen. Wird eine ganze Serie von baugleichen oder quasi-baugleichen Getrieben mit erfindungsgemäßen Luftfiltereinrichtungen ausgestattet, so kann auch eine Datenbasis für eine Serienanalyse geschaffen werden, die häufig auch als Flottenanalyse bezeichnet wird.

Gemäß einer Ausgestaltung der vorliegenden Erfindung weist die Luftfiltereinrichtung einen Ölanalysesensor auf, der für Gase über den Strömungskanal zugänglich positioniert ist, wobei es sich bei dem Ölanalysesensor bevorzugt um einen Mikro-Gaschromatograph handelt. Entsprechend kann der Ist-Zustand des Öls jederzeit bestimmt und ein optimaler Zeitpunkt für eine Nachbehandlung des Öls oder einen Ölwechsel bestimmt werden.

Alternativ oder zusätzlich kann die Luftfiltereinrichtung einen Temperatursensor aufweisen, um die Ist-Betriebstemperatur zu erfassen. Wird ein Ölanalysesensor mit einem Temperatursensor kombiniert, so kann der Ölanalysesensor derart programmiert werden, dass er Proben nur in Phasen ansteigender Temperatur entnimmt und analysiert, also nur dann, wenn der Druck im Innenraum des Getriebegehäuses größer ist als der Umgebungsdruck. Auf diese Weise kann sichergestellt werden, dass die entnommenen Proben ausschließlich aus dem Innenraum des Getriebes stammen und entsprechend Öldampf enthalten.

Gemäß einer weiteren Ausgestaltung weist die Luftfiltereinrichtung alternativ oder zusätzlich einen Schwingungssensor auf, beispielsweise in Form eines Beschleunigungssensors auf MEMS-Basis oder eines Piezzo-Beschleunigungsaufnehmers, so dass auch die erfassten Schwingungen zur Beurteilung des Getriebezustands herangezogen werden können.

Bevorzugt weist die Luftfiltereinrichtung einen Mikrocontroller auf, an den der zumindest ein Sensor datentechnisch angebunden ist. Unter Einsatz eines Mikrocontrollers können die Messsignale des zumindest einen Sensors aufbereitet werden, bevor sie an eine Auswerteeinrichtung weitergeleitet werden. Alternativ ist es natürlich auch möglich, die Messsignale bzw. Rohsignale des zumindest einen Sensors als Analogsignale oder digitale Bussignale an eine Auswerteeinrichtung auszugeben.

Vorteilhaft weist die Luftfiltereinrichtung zumindest eine Batterie auf, um die elektronischen Komponenten der Luftfiltereinrichtung mit Strom zu versorgen. Dank einer solchen autonomen Stromquelle kann auf eine entsprechende Verkabelung der Luftfiltereinrichtung verzichtet werden.

Gemäß einer Ausgestaltung weist die erfindungsgemäße Luftfiltereinrichtung einen Grundkörper und ein an dem Grundkörper gehaltenes Deckelelement auf, wobei der zumindest eine Sensor und/oder der Mikrocontroller und/oder die zumindest eine Batterie an dem Grundkörper gehalten ist/sind, insbesondere innerhalb eines am Grundkörper ausgebildeten Aufnahmeraums, der Grundkörper und das Deckelelement gemeinsam den Strömungskanal bilden, und das zumindest eine Filterelement am Deckelelement angeordnet ist. Auf diese Weise wird ein sehr einfacher Aufbau der Luftfiltereinrichtung erzielt.

Bevorzugt weist der Grundkörper einen auswärts vorstehenden, mit einem Außengewinde versehenen hohlzylindrischen Befestigungsabschnitt auf, der in eine am Getriebegehäuse vorgesehene Gewindebohrung eingeschraubt werden kann. Dies erleichtert die Montage der Luftfiltereinrichtung.

Vorteilhaft ist das Deckelelement auf den Grundkörper geschraubt, so dass die am Grundkörper und am Deckelelement aufgenommenen Komponenten einfach für das Wartungspersonal zugänglich sind.

Ferner schafft die vorliegende Erfindung ein Getriebe mit einem Getriebegehäuse und einer an dem Getriebegehäuse befestigten erfindungsgemäßen Luftfiltereinrichtung.

Gemäß einer Ausgestaltung des erfindungsgemäßen Getriebes ist ein mit einem Außengewinde versehener hohlzylindrischer Befestigungsabschnitt der Luftfiltereinrichtung in eine Gewindedurchgangsbohrung des Getriebegehäuses eingeschraubt.

Zudem schafft die vorliegende Erfindung ein Verfahren zur Inbetriebnahme und zur Verwendung eines erfindungsgemäßen Getriebes, aufweisend die Schritte:
a) Definieren von Grenzwerten für die von dem zumindest einen Sensor erfasste Messgröße und Speichern der Grenzwerte in einem Computersystem,
b) Vergleichen der während des Betriebs des Getriebes von dem zumindest einen Sensor erfassten Messgrößen mit den Grenzwerten und
c) Ausgeben eines Alarms, wenn die in Schritt b) erfassten Messgrößen einen oberen Grenzwert überschreiten oder einen unteren Grenzwert unterschreiten.
Das erfindungsgemäße Verfahren ermöglicht damit eine computergestützte, zustandsbezogene Wartung des Getriebes.

Bevorzugt werden im Rahmen einer initialen Lernphase, in der im Verlauf der Lebensdauer des Getriebes zu erwartende Betriebszustände durchlaufen werden, Soll-Werte für die einzelnen Betriebszustände erfasst, woraufhin basierend auf den Soll-Werten in Schritt a) Grenzwerte für die jeweiligen Betriebszustände definiert werden. Das Betriebsverhalten eines Getriebes hängt von den Einbaubedingungen vor Ort ab. Entsprechend liefert die Durchführung einer Lernphase vor Ort für den Anlagetyp charakteristische Soll-Werte für die jeweiligen Betriebszustände.

Gemäß einer Ausgestaltung des erfindungsgemäßen Verfahrens wird die Lernphase nach jeder Wartung wiederholt und während der erneuten Lernphase neue Soll-Werte erfasst. Sollten sich die Soll-Werte gegenüber den Soll-Werten der vorangegangenen Lernphase geändert haben, werden neue Grenzwerte basierend auf den neuen Soll-Werten definiert und gespeichert. Auf diese Weise können Änderungen, die auf den bisherigen Betrieb und/oder auf die Wartungsarbeiten zurückzuführen sind, zukünftig mit in die zustandsbezogene Auswertung einbezogen werden. Solche Änderungen können beispielsweise auf den zunehmenden Verschleiß einzelner Getriebekomponenten, auf die Verwendung einer neuen Ölzusammensetzung, den Austausch einzelner Komponenten oder dergleichen zurückzuführen sein.

Bevorzugt werden im Rahmen einer Wartung festgestellten Ursachen für eine Grenzwertüber- oder -unterschreitung der entsprechenden Grenzwertüber- oder -unterschreitung zugeordnet und gespeichert, und die gespeicherten Ursachen werden bei einer erneuten Grenzwertüber- oder -unterschreitung angezeigt. Entsprechend lernt das System von Wartung zu Wartung, so dass immer spezifischere zustandsbezogene Aussagen gemacht werden können. Auch können Ursachen für eine Grenzwertüber- oder -unterschreitung, die bei unterschiedlichen Anlagen desselben Anlagetyps festgestellt wurden, in einer gemeinsamen Datenbank gespeichert werden, wodurch die Lerngeschwindigkeit erhöht wird.

Ferner schafft die Erfindung einen Antriebsstrang, umfassend eine Rotorwelle, die drehmomentübertragend mit einem Getriebe verbunden ist, welches wiederrum drehmomentübertragend mit einem Generator verbunden ist, wobei das Getriebe als erfindungsgemäßes Getriebe ausgebildet ist.

Zudem schafft die vorliegende Erfindung eine Windkraftanlage, umfassend einen Rotor, der an einer Gondel angebracht ist, wobei in der Gondel ein Antriebsstrang angeordnet ist, der drehmomentübertragend mit dem Rotor verbunden ist, wobei der Antriebsstrang als erfindungsgemäßer Antriebsstrang ausgebildet ist.

Darüber hinaus schafft die vorliegende Erfindung eine Industrie-Applikation, umfassend ein Antriebsmittel, das mit einem Getriebe drehmomentübertragend verbunden ist, das mit einer mechanischen Anwendung drehmomentübertragend gekoppelt ist, wobei das Getriebe als erfindungsgemäßes Getriebe ausgebildet ist.

Hinsichtlich weiterer vorteilhafter Ausgestaltungen der Erfindung wird auf die Unteransprüche sowie auf die nachfolgende Beschreibung von Ausführungsbeispielen unter Bezugnahme auf die beiliegende Zeichnung verwiesen.

In der Zeichnung ist
- FIG 1: eine schematische Seitenansicht eines Getriebes gemäß einer Ausführungsform der vorliegenden Erfindung;
- FIG 2: eine teilweise geschnittene vergrößerte schematische Ansicht des in FIG 1 mit der Ziffer II gekennzeichneten Ausschnitts und zeigt eine an dem Getriebe angeordnete Luftfiltereinrichtung;
- FIG 3: eine analog zu FIG 2, die eine Luftfiltereinrichtung gemäß einer weiteren Ausführungsform der vorliegenden Erfindung zeigt;
- FIG 4: eine geschnittene schematische Seitenansicht einer Ausführungsform einer erfindungsgemäßen Windkraftanlage;
- FIG 5: eine schematische Darstellung einer Ausführungsform eines erfindungsgemäßen Antriebsstrangs; und
- FIG 6: eine schematische Darstellung einer Ausführungsform einer erfindungsgemäßen Industrie-Applikation.

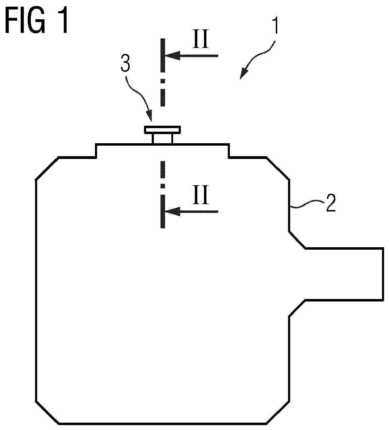

FIG 1 zeigt ein Getriebe 1 gemäß einer Ausführungsform der vorliegenden Erfindung. Das Getriebe 1 umfasst ein Getriebegehäuse 2, das in bekannter Weise die vorliegend nicht näher dargestellten Getriebekomponenten aufnimmt. Das Getriebegehäuse 2 ist teilweise mit Öl gefüllt, um die Getriebekomponenten zu schmieren und/oder zu kühlen. Entsprechend ist der Innenraum des Getriebegehäuses 2 in einen Ölsumpf und in ein Luftvolumen unterteilt. Durch die Erwärmung während des Betriebs kommt es zu einer Volumenänderung des Öls, welche bei geschlossenem Getriebegehäuse 2 zu einer Druckänderung führt. Um Beschädigungen von Getriebekomponenten aufgrund eines Überdrucks innerhalb des Getriebegehäuses 2 zu vermeiden, wie beispielsweise Beschädigungen von Wellendichtringen oder dergleichen, ist an dem Getriebegehäuse 2 eine Luftfiltereinrichtung 3 vorgesehen, die dazu ausgelegt ist, einen Druckausgleich zwischen dem Innenraum des Getriebes 1 und der Umgebung zu ermöglichen, genauer gesagt zwischen dem Luftvolumen des Getriebegehäuses 2 und der Umgebung.

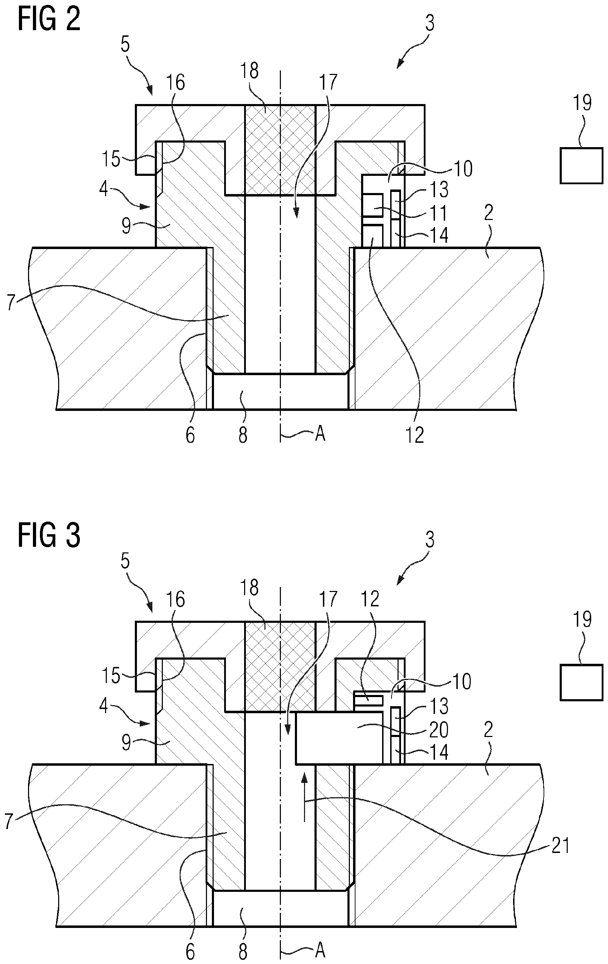

FIG 2 zeigt eine vergrößerte, teilweise geschnittene Ansicht des der am Getriebegehäuse 2 angeordneten Luftfiltereinrichtung 3. Bei der vorliegend dargestellten Ausführungsform umfasst die Luftfiltereinrichtung 3 einen Grundkörper 4 und ein an dem Grundkörper 4 gehaltenes Deckelelement 5. Der Grundkörper 4 weist an seinem freien Ende einen mit einem Außengewinde 6 versehenen hohlzylindrischen Befestigungsabschnitt 7 auf, der in eine am Getriebegehäuse 2 vorgesehene Gewindedurchgangsbohrung 8 geschraubt ist. Das andere freie Ende des Grundkörpers 4 bildet vorliegend einen Aufnahmeabschnitt 9, der sich an den Befestigungsabschnitt 7 anschließt und einen größeren Außendurchmesser als der Befestigungsabschnitt 7 hat. Der Aufnahmeabschnitt bildet einen Aufnahmeraum 10, in dem vorliegend ein Schwingungssensor 11, ein Temperatursensor 12, ein Mikrocontroller 13 und eine Batterie 14 aufgenommen sind, wobei die Batterie 14 den Schwingungssensor 11, den Temperatursensor 12 und den Mikrocontroller 13 mit Energie versorgt. Im oberen Bereich ist der Aufnahmeraum 10 des Grundkörpers 4 mit einem Außengewinde 15 versehen, das mit einem Innengewinde 16 des Deckelelementes 5 verschraubt ist. Entsprechend ist das Deckelelement 5 vorliegend lösbar an dem Grundkörper 4 gehalten und bedeckt im aufgeschraubten Zustand den Aufnahmeraum 10. Der Grundkörper 4 und das Deckelelement 5 bilden gemeinsam einen Strömungskanal 17, der sich vorliegend mittig in axialer Richtung A durch den Grundkörper 4 und das Deckelelement 5 erstreckt und den Innenraum des Getriebegehäuses 2 mit der Umgebung verbindet. In den Strömungskanal 17 ist ein Filterelement 18 eingesetzt, das dazu dient, den Strömungskanal 17 passierende Medien zu filtern. Bei dem Filterelement 18 kann es sich beispielsweise um einen reinen Luftfilter handeln, der Partikel aus den Strömungskanal 17 durchströmenden Medien filtert. Alternativ kann als Filterelement 18 aber auch ein Nassluftfilter eingesetzt werden, um zusätzlich zu verhindern, dass Feuchtigkeit aus der Umgebung in den Innenraum des Getriebes 1 gelangen kann. Ebenso ist es möglich, dass mehrere verschiedene Filterelemente in den Strömungskanal 17 eingesetzt werden. Das Filterelement 18 ist vorliegend in denjenigen Teilbereich des Strömungskanals 17 eingesetzt, der durch das Deckelelement 5 gebildet wird.

Während des Betriebs des Getriebes 1 nimmt der Schwingungssensor 11, der beispielsweise in Form eines Beschleunigungssensors auf MEMS-Basis oder in Form eines Piezzo-Beschleunigungsaufnehmers vorgesehen sein kann, Schwingungen des Getriebes auf. Der Temperatursensor 12 erfasst die Ist-Temperatur im Bereich der Luftfiltereinrichtung 3. Die Sensorsignale des Schwingungssensors 11 und des Temperatursensors 12 werden vorliegend an den Mikrocontroller 13 übermittelt, dort aufbereitet und dann drahtgebunden oder drahtlos an eine Auswerteeinrichtung 19 weitergeleitet. In der Auswerteeinrichtung werden die empfangenen Daten mit vorab definierten Grenzwerten verglichen. Basierend auf dem Vergleichsergebnis werden dann Rückschlüsse auf den Ist-Zustand des Getriebes 1 gezogen.

Zur Festlegung der Grenzwerte wird vor der eigentlichen Inbetriebnahme des Getriebes 1 eine initiale Lernphase durchgeführt. Im Rahmen dieser Lernphase werden im Verlauf der Lebensdauer des Getriebes 1 zu erwartende Betriebszustände durchlaufen. Dabei werden Ist-Schwingungen und Ist-Temperaturen von den Sensoren 11 und 12 aufgenommen und auf diesen Ist-Werten basierend Soll-Werte für die einzelnen Betriebszustände erfasst. Auf Basis der Soll-Werte werden dann Grenzwerte für die jeweiligen Betriebszustände definiert und gespeichert, die nicht über- oder unterschritten werden dürfen. So kann beispielsweise ein einzelner Schwingungs-Grenzwert als Obergrenze für Schwingungen und ein einzelner Temperatur-Grenzwert als Obergrenze für die Temperatur definiert werden. Es wird allerdings bevorzugt, dass verschiedenen Betriebszuständen unterschiedliche Schwingungs- und/oder Temperatur-Grenzwerte zugeordnet werden. Die Betriebszustände können dann beispielsweise anhand weiterer überwachter Parameter definiert werden, wie beispielsweise anhand unterschiedlicher Temperaturklassen, da bei unterschiedlichen Temperaturen bedingt durch die veränderte Ölviskosität und ausdehnungsbedingte Verspannungen des gesamten Getriebesystems auch ein unterschiedliches Frequenzverhalten zu erwarten ist. Weitere Kriterien zu Definition unterschiedlicher Betriebszustände des Getriebes 1 können auch überwachte Parameter aus der Automatisierung sein, wie Drehzahl, Leistung oder dergleichen, anhand derer Betriebszustände voneinander unterschieden werden können.

Während des normalen Betriebs des Getriebes 1 werden die von den Sensoren 11 und 12 erfassten und vom Mikrocontroller 13 aufbereiteten Daten an die Auswerteeinrichtung 19 übermittelt und analysiert, indem die erfassten Messgrößen mit den zugehörigen Grenzwerten verglichen werden. Überschreitet eine der erfassten Messgrößen einen oberen Grenzwert oder unterschreitet einen unteren Grenzwert, so wird bevorzugt ein Alarm ausgegeben, der dem Wartungspersonal anzeigt, dass eine Wartung durchgeführt werden muss.

Im Rahmen der Wartung wird dann vom Wartungspersonal nach Ursachen für die entsprechende Grenzwertüberschreitung gesucht. Aufgefundene Ursachen werden in der Auswerteeinrichtung 19 gespeichert, so dass dem Wartungspersonal zusätzlich zu einem Alarmsignal zukünftig auch eine mögliche Ursache von der Auswerteeinrichtung 19 angezeigt werden kann.

Nach erfolgter Wartung wird vorteilhaft erneut eine Lernphase durchgeführt, im Rahmen derer neue Soll-Werte erfasst und, sollten sich die Soll-Werte gegenüber den Soll-Werten der vorangegangenen Lernphase geändert haben, neue Grenzwerte basierend auf den neuen Soll-Werten definiert und gespeichert werden. Auf diese Weise können Änderungen, die auf den bisherigen Betrieb und/oder auf die Wartungsarbeiten zurückzuführen sind, zukünftig mit in die zustandsbezogene Auswertung einbezogen werden. Solche Änderungen können beispielsweise auf den zunehmenden Verschleiß einzelner Getriebekomponenten, auf die Verwendung einer neuen Ölzusammensetzung, den Austausch einzelner Komponenten oder dergleichen zurückzuführen sein.

Das erfindungsgemäße Getriebe 1 zeichnet sich dadurch aus, dass die Luftfiltereinrichtung 3 neben dem oder den Filterelementen 18 auch die Sensoren 11 und 12, den Mikrocontroller 13 und die Batterie 14 aufnimmt, was zu einem sehr kompakten und leicht zu montierenden Getriebeaufbau führt. Es ist nicht länger erforderlich, die Sensoren 11 und 12 separat innerhalb des Getriebegehäuses 2 zu installieren und aufwändig mit einer Stromversorgung zu verbinden. Die integrale Ausbildung der Sensoren 10 und 11 und der Luftfiltereinrichtung 3 ermöglicht auch eine sehr einfache Aufrüstung eines Bestandsgetriebes zu einem smarten bzw. digitalen Getriebe. Im einfachsten Fall muss lediglich eine herkömmliche Luftfiltereinrichtung durch eine erfindungsgemäße Luftfiltereinrichtung 3 ersetzt werden. Die gleichbleibende Positionierung der Sensoren 10 und 11 an der Luftfiltereinrichtung 3 ermöglicht zudem einen direkten Vergleich mehrerer Getriebe gleicher oder ähnlicher Bauart, die in gleichen oder ähnlichen Anlagen verbaut sind, wenn sämtliche Getriebe mit erfindungsgemäßen Luftfiltereinrichtungen 3 ausgestattet sind. In diesem Fall können die Ursachen für Grenzwertüber- oder Unterschreitungen, die bei Wartungsarbeiten ermittelt werden, in einem zentralen Datenspeicher oder in einer Cloud gespeichert werden, auf die sämtliche Auswerteeinrichtungen 19 Zugriff haben. Auf diese Weise kann das System von den Erfahrungen lernen, die mit einer Vielzahl von Getrieben 1 gemacht wurden, wodurch die Lerngeschwindigkeit des Systems deutlich verbessert wird.

FIG 3 zeigt eine Luftfiltereinrichtung 3 gemäß einer zweiten Ausführungsform der vorliegenden Erfindung, deren Aufbau in großen Teilen dem Aufbau der zuvor beschriebenen Luftfiltereinrichtung 3 entspricht, weshalb an dieser Stelle auf Wiederholungen verzichtet wird. Die in FIG 3 dargestellte Luftfiltereinrichtung 3 unterscheidet sich dahingehend von der in FIG 2 gezeigten Luftfiltereinrichtung 3, dass anstelle eines Schwingungssensors 11 ein Ölanalysesensor 20 vorgesehen ist, der vorliegend als Mikro-Gaschromatograph ausgebildet ist. Der Ölanalysesensor 20 ist derart positioniert, dass er für Gase über den Strömungskanal 17 zugänglich positioniert ist, wie es in FIG 3 durch den Pfeil 21 angedeutet ist. Entsprechend kann der Ist-Zustand des Öls jederzeit durch Entnahme und Analyse von Öldampfproben bestimmt und ein optimaler Zeitpunkt für eine Nachbehandlung des Öls oder einen Ölwechsel bestimmt werden. Proben werden dabei bevorzugt nur in Phasen ansteigender Temperatur entnommen und analysiert, also nur dann, wenn der Druck im Innenraum des Getriebegehäuses 2 größer ist als der Umgebungsdruck. Auf diese Weise kann sichergestellt werden, dass die entnommenen Proben ausschließlich aus dem Innenraum des Getriebes stammen und entsprechend Öldampf enthalten.

Es sollte klar sein, dass erfindungsgemäße Luftfiltereinrichtungen 3 mit unterschiedlichsten Sensoren und Sensorkombinationen ausgestattet werden können. In dieser Kombination entstehen viele unterschiedliche Sensordaten die über Grenzwerte überwacht werden sollen. Dies kann mit Hilfe neuronaler Netze vorteilhaft gelöst werden. Hierbei lernt das neuronale Netz die Korrelationen zwischen den Messdaten und bestimmt eine Abweichung vom erlernten Zustand über einen dimensionslosen Abweichungsindex. Je, größer die Abweichung, desto wahrscheinlicher ist das Vorliegen eines anderen Betriebszustandes bzw. Fehlerzustandes. Ähnliche Korrelationsmuster entsprechen einem Korrelationskluster, das einem Betriebszustand bzw. Fehlerzustand des Getriebes mit seinem Öl durch Labeling zugeordnet werde kann. Das Labeling bestimmt die Kausalität, also z.B. die Ursache und Bedingungen für den entsprechenden Betriebszustand. Das Labeling selbst wird durch das Betriebspersonal während der Lernphase durchgeführt und entspricht dem Setzen der Grenzwerte im vorherigen Abschnitt.

Bei entsprechend großer Zahl an unterschiedlicher Sensordaten und häufiger Messfrequenz kann die Berechnung des neuronalen Netzes sehr rechenintensiv werden, was durch eine Verlagerung der Berechnungen in eine Rechner Cloud gelöst werden kann. Die Messeinheit 19 befindet sich in dem Fall also in einer Rechner Cloud und wird durch eine zugehörige Gateway Einheit vor Ort mit den jeweiligen Messdaten versorgt. Die Rechner Cloud kann dabei auf der Anlage des Kunden stehen und von ihm selbst gewartet werden oder es kann sich um eine Rechner Cloud eines Dienstleisters handeln.

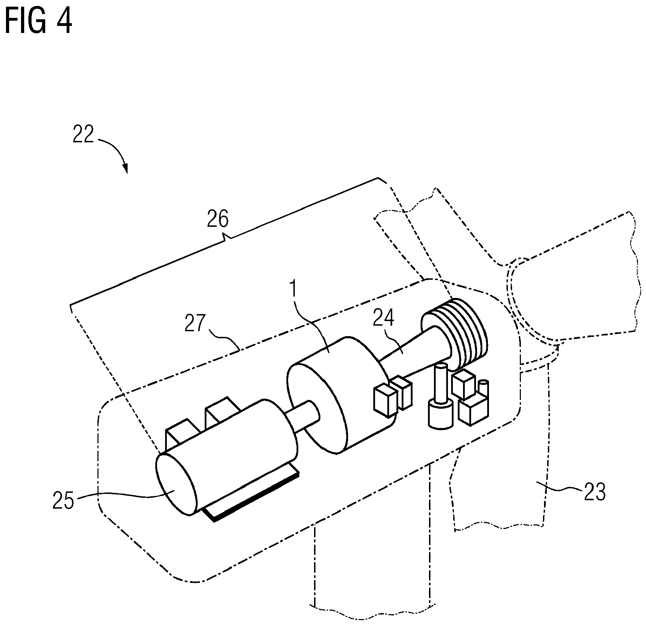

In FIG 4 ist eine geschnittene Schrägansicht einer Ausführungsform einer erfindungsgemäßen Windkraftanlage 22 dargestellt. Die Windkraftanlage 22 umfasst einen Rotor 23, der durch Wind in Drehung versetzbar ist. Der Rotor 23 ist über eine Rotorwelle 24 mit einem erfindungsgemäßen Getriebe 1 drehmomentübertragend verbunden. Das Getriebe 1 ist wiederum drehmomentübertragend mit einem Generator 25 verbunden. Die Rotorwelle 24, das Getriebe 1 und der Generator 25 gehören zu einem Antriebsstrang 26, der in einer Gondel 27 der Windkraftanlage 22 aufgenommen ist. Der Generator 25 weist 2, 3 oder 4 Polpaare auf.

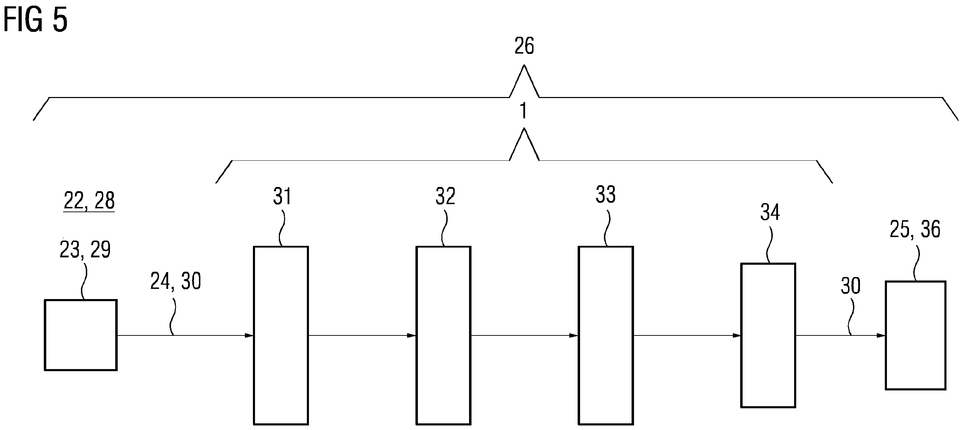

FIG 5 zeigt einen schematischen Aufbau einer weiteren Ausführungsform eines erfindungsgemäßen Antriebsstrangs 26, der in einer nicht näher dargestellten Windkraftanlage 22 oder in einer nicht näher dargestellten Industrieapplikation 28 einsetzbar ist. Der Antriebsstrang 26 umfasst ein erfindungsgemäßes Getriebe 1, das eingangsseitig mit einem Antriebsmittel 29 oder einem Rotor 23 der Windkraftanlage 22 verbunden ist und dem so eine Antriebsleistung 30 zugeführt wird. In einer Windkraftanlage 22 erfolgt dies mittels einer Rotorwelle 24. Das Getriebe 1 umfasst vorliegend Planetenstufen 31, 32, 33 sowie eine Stirnradstufe 34, die hintereinander angeordnet sind. Die Getriebestufen 31, 32, 33 und die Stirnradstufe 34 geben eine Abtriebsleistung 34 an einen Generator 25 oder eine mechanische Anwendung 35 ab.

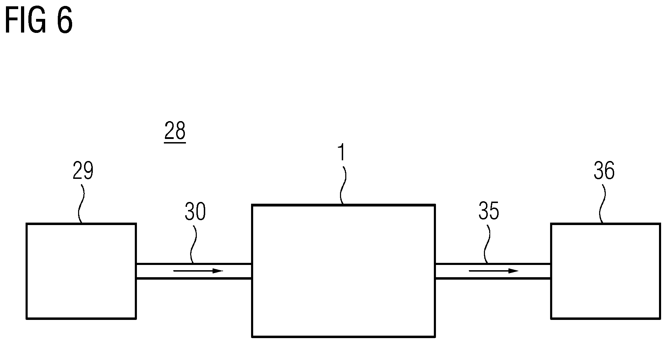

In FIG 6 ist schematisch der Aufbau einer Ausführungsform einer Industrie-Applikation 28 dargestellt, die über ein Antriebsmittel 29 verfügt. Das Antriebsmittel 29 ist dazu ausgebildet, eine Antriebsleistung 30 bereitzustellen, die durch eine drehmomentübertragende Verbindung an ein erfindungsgemäßes Getriebe 1 transportiert wird. Das Getriebe 1 ist wiederum drehmomentübertragend mit einer mechanischen Anwendung 35 verbunden, um eine Abtriebsleistung 34 zur mechanischen Anwendung 35 zu transportieren.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Luftfiltereinrichtung (3), die dazu ausgelegt ist, einen Druckausgleich zwischen dem Innenraum eines Getriebes (1) und der Umgebung zu ermöglichen, umfassend einen Strömungskanal (17) und zumindest ein in den Strömungskanal (17) eingesetztes Filterelement (18), **dadurch gekennzeichnet, dass** die Luftfiltereinrichtung (3) zumindest einen Sensor (11, 12, 20) zur Erfassung einer den Betriebszustand des Getriebes (1) repräsentierenden Messgröße aufweist.

2. Luftfiltereinrichtung (3) nach Anspruch 1, **dadurch gekennzeichnet, dass** diese einen Ölanalysesensor (20) aufweist, der für Gase über den Strömungskanal (17) zugänglich positioniert ist.

3. Luftfiltereinrichtung (3) nach Anspruch 1 oder 2, **dadurch gekennzeichnet, dass** diese einen Temperatursensor (12) aufweist.

4. Luftfiltereinrichtung (3) nach einem der vorhergehenden Ansprüche, **dadurch gekennzeichnet, dass** diese einen Schwingungssensor (11) aufweist.

5. Luftfiltereinrichtung (3) nach einem der vorhergehenden Ansprüche, **dadurch gekennzeichnet, dass** diese einen Mikrocontroller (13) aufweist, an den der zumindest eine Sensor (11, 12, 20) datentechnisch angebunden ist.

6. Luftfiltereinrichtung (3) nach einem der vorhergehenden Ansprüche, **dadurch gekennzeichnet, dass** diese zumindest eine Batterie (14) aufweist.

7. Luftfiltereinrichtung (3) nach einem der vorhergehenden Ansprüche, **dadurch gekennzeichnet, dass** diese einen Grundkörper (4) und ein an dem Grundkörper (4) gehaltenes Deckelelement (5) aufweist, wobei der zumindest eine Sensor (11, 12, 20) und/oder der Mikrocontroller (13) und/oder die zumindest eine Batterie (14) an dem Grundkörper (4) gehalten ist/sind, insbesondere innerhalb eines am Grundkörper (24) ausgebildeten Aufnahmeraums (10), der Grundkörper (4) und das Deckelelement (5) gemeinsam den Strömungskanal (17) bilden und das zumindest eine Filterelement (18) am Deckelelement (5) angeordnet ist.

8. Luftfiltereinrichtung (3) nach Anspruch 7, **dadurch gekennzeichnet, dass** der Grundkörper (4) einen auswärts vorstehenden, mit einem Außengewinde (6) versehenen hohlzylindrischen Befestigungsabschnitt (7) aufweist.

9. Luftfiltereinrichtung (3) nach Anspruch 7 oder 8, **dadurch gekennzeichnet, dass** das Deckelelement (5) auf den Grundkörper (4) geschraubt ist.

10. Getriebe (1) mit einem Getriebegehäuse (2) und einer an dem Getriebegehäuse (2) befestigten Luftfiltereinrichtung (3) nach einem der vorhergehenden Ansprüche.

11. Getriebe (1) nach Anspruch 10, **dadurch gekennzeichnet, dass** ein mit einem Außengewinde (6) versehener hohlzylindrischer Befestigungsabschnitt (7) der Luftfiltereinrichtung (3) in eine Gewindedurchgangsbohrung (8) des Getriebegehäuses (2) eingeschraubt ist.

12. Verfahren zur Inbetriebnahme und zur Verwendung eines Getriebes (1) nach Anspruch 10 oder 11, aufweisend die Schritte:
a) Definieren von Grenzwerten für die von dem zumindest einen Sensor (11, 12, 20) erfasste Messgröße und speichern der Grenzwerte in einem Computersystem,
b) Vergleichen der während des Betriebs des Getriebes (1) von dem zumindest einen Sensor (11, 12, 20) erfassten Messgrößen mit den Grenzwerten und
c) Ausgeben eines Alarms, wenn die in Schritt b) erfassten Messgrößen einen oberen Grenzwert überschreiten oder einen unteren Grenzwert unterschreiten.

13. Verfahren nach Anspruch 12, **dadurch gekennzeichnet, dass** im Rahmen einer initialen Lernphase, in der im Verlauf der Lebensdauer des Getriebes (1) zu erwartende Betriebszustände durchlaufen werden, Soll-Werte für die einzelnen Betriebszustände erfasst werden, woraufhin basierend auf den Soll-Werten in Schritt a) Grenzwerte für die jeweiligen Betriebszustände definiert werden.

14. Verfahren nach Anspruch 13, **dadurch gekennzeichnet, dass** die Lernphase nach jeder Wartung wiederholt wird, neue Soll-Werte erfasst werden und, sollten sich die Soll-Werte gegenüber den Soll-Werten der vorangegangenen Lernphase geändert haben, neue Grenzwerte basierend auf den neuen Soll-Werten definiert und gespeichert werden.

15. Verfahren nach einem der Ansprüche 12 bis 14, **dadurch gekennzeichnet, dass** im Rahmen einer Wartung festgestellten Ursachen für eine Grenzwertüber- oder -unterschreitung der entsprechenden Grenzwertüber- oder -unterschreitung zugeordnet und gespeichert werden, und dass die gespeicherten Ursachen bei einer erneuten Grenzwertüber- oder -unterschreitung angezeigt werden.

16. Antriebsstrang (26), umfassend eine Rotorwelle (24), die drehmomentübertragend mit einem Getriebe (1) verbunden ist, welches wiederrum drehmomentübertragend mit einem Generator (25) verbunden ist, **dadurch gekennzeichnet, dass** das Getriebe (1) nach einem der Ansprüche 10 oder 11 ausgebildet ist.

17. Windkraftanlage (22), umfassend einen Rotor (23), der an einer Gondel (27) angebracht ist, wobei an der Gondel (27) ein Antriebsstrang (26) angeordnet ist, der drehmomentübertragend mit dem Rotor (23) verbunden ist, **dadurch gekennzeichnet, dass** der Antriebsstrang (26) nach Anspruch 16 ausgebildet ist.

18. Industrie-Applikation (28), umfassend ein Antriebsmittel (29), das mit einem Getriebe (1) drehmomentübertragend verbunden ist, das mit einer mechanischen Anwendung (36) drehmomentübertragend gekoppelt ist, **dadurch gekennzeichnet, dass** das Getriebe (1) nach einem der Ansprüche 10 oder 11 ausgebildet ist.
